# EUROPÄISCHE PATENTSCHRIFT

(11) **EP 0 453 023 B1**
(45) Veröffentlichungstag und Bekanntmachung des Hinweises auf die Patenterteilung: **17.07.1996**
(21) Anmeldenummer: 91200847.1
(22) Anmeldetag: 11.04.1991
(51) Int. Cl.: H05K 1/11

(54) **Verfahren und eine flexible Leiterplatte zum Kontaktieren von mindestens einer zu kontaktierenden Kontaktfläche mit derselben**
Flexible circuit board and method for contacting at least one contact surface with the circuit board
Plaque de circuit flexible et procédé pour établir le contact d'au moins une surface de contact avec la plaque de circuit

(30) Priorität: 14.04.1990 DE 4012077
(43) Veröffentlichungstag der Anmeldung: 23.10.1991
(73) Patentinhaber: Philips Patentverwaltung GmbH, 22335 Hamburg (DE); Philips Electronics N.V., 5621 BA Eindhoven (NL)
(72) Erfinder: Schultes, Günter, Dr., W-2070 Ahrensburg (DE); Stolte, Jürgen, W-2000 Hamburg 60 (DE); Eyers, Axel, Dr., W-2000 Hamburg 65 (DE); Krause, Matthias, W-2000 Hamburg 73 (DE)
(74) Vertreter: Hartmann, Heinrich, Dipl.-Ing.

(56) Entgegenhaltungen:
- EP-A- 0 227 850
- EP-A- 0 295 446
- US-A- 4 403 272
- US-A- 4 906 803

## Beschreibung

Die Erfindung betrifft ein Verfahren zum Kontaktieren von mindestens einer zu kontaktierenden Kontaktfläche mit einer mit einer Leiterbahn verbundenen Kontaktzone einer flexiblen Leiterplatte, wobei die Leiterplatte derart befestigt wird, daß deren Kontaktzonen mit den Kontaktflächen aufeinanderliegend korrespondieren. Ferner betrifft die Erfindung eine flexible Leiterplatte zur Ausführung des Verfahrens für einen mit mindestens einem Meßfühler versehenen Meßwertaufnehmer, mit Kontaktstellen für Bauelemente einer auf ihr ausgebildeten Abgleichschaltung, mit Kontaktstellen für Anschlußleitungen und Kontaktzonen zur Verbindung mit dem Meßfühler.

Flexible Leiterplatten werden als Verbindungsglied und als Träger für Abgleichschaltungen insbesondere in Wägezellen und Druckaufnehmern mit als Dehnungsmeßstreifen ausgebildeten Meßfühlern eingesetzt.

Aus der europäischen Patentanmeldung O 227 850 A1 ist ein Kraftaufnehmer bekannt, der eine als Doppelbiegebalken ausgebildete Meßfeder aufweist, auf dessen oberer und unterer Fläche Dehnungsmeßstreifen aufgebracht sind. Die Dehnungsmeßstreifen sind über eine Verdrahtung, die als flexible Printplatte ausgebildet sein kann, an einem Ende der Meßfeder von deren oberen Fläche um eine Stirnseite herum zur unteren Meßfederfläche geführt. Abgleichwiderstände für einen Nullpunktabgleich sind in der Verdrahtung integriert. Die Anschlußpunkte der flexiblen Printplatte zum Anschluß der Dehnungsmeßstreifen sind einander gegenüberliegend angeordnet und können mit einem anzulötenden Draht verbunden werden. Diese Verbindung herzustellen, ist verhältnismäßig aufwendig, wenig platzsparend, benötigt je Verbindung mindestens zwei Lötstellen und entsprechend viel Material und Zeit beim Montieren des Kraftaufnehmers. Die Anschlußleitungen bei diesem Kraftaufnehmer werden in gleicher Weise mit der flexiblen Leiterplatte verlötet und dann vom Kraftaufnehmer weggeführt.

Aus der US-A 47 95 079 ist ein Verfahren zur Kontaktierung einer flexiblen Leiterplatte mit einer zweiten Leiterplatte bekannt. Eine schnelle und gute Kontaktierung wird mit diesem Verfahren dadurch erreicht, daß auf die Kontaktfläche der ersten Leiterplatte ein Lot aufgebracht ist, daß die zweite Leiterplatte eine dazu korrespondierende Kontaktfläche aufweist, daß gegenüber dieser Kontaktfläche auf der Rückseite der zweiten Leiterplatte eine thermisch leitende Schicht aufgebracht ist, daß die Kontaktflächen der beiden Leiterplatten aufeinandergelegt werden (wobei sich zwischen den Kontaktflächen das auf die Kontaktfläche der ersten Leiterplatte aufgebrachte Lot befindet) und daß durch Hitzezufuhr über die thermisch leitende Schicht das Lot zum Schmelzen gebracht wird, wodurch schließlich die Kontaktierung erfolgt.

Aufgabe der vorliegenden Erfindung ist es, ein Verfahren zum einfachen und automatisierbaren Kontaktieren von mindestens einer zu kontaktierenden Kontaktfläche mit einer Leiterbahn verbundenen Kontaktzone einer flexiblen Leiterplatte zu schaffen und ferner eine flexible Leiterplatte zur Ausführung des Verfahrens anzugeben, die einfach aufgebaut ist und direkt und platzsparend mit beispielsweise Meßfühlern verbindbar ist und eine möglichst einfache und automatisierbare Montage gewährleistet.

Diese Aufgabe wird hinsichtlich des Verfahrens erfindungsgemäß dadurch gelöst, daß im Bereich der Kontaktzonen, die mindestens ein in die Leiterplatte integriertes und von beiden Seiten freigelegtes Anschlußelement aufweist, von der den Kontaktflächen abgewandten, freiliegenden Seite ein Lot aufgebracht wird zur Kontaktierung der Kontaktzonen mit den Kontaktflächen.

Hinsichtlich der flexiblen Leiterplatte wird die Aufgabe erfindungsgemäß dadurch gelöst, daß die Kontaktzonen der Leiterplatte mit den Kontaktflächen der Meßfühler korrespondieren und aufeinander befestigt zusammenwirken, und daß jede Kontaktzone mindestens ein in die Leiterplatte integriertes und von beiden Seiten freigelegtes Anschlußelement aufweist und über dieses direkt mit den entsprechenden Kontaktflächen kontaktierbar ist.

Vorteilhaft kann die Leiterplatte einen Bereich mit einer Klebevorrichtung zur Befestigung auf dem Meßwertaufnehmer aufweisen, auf dem die Meßfühler angeordnet sind. Als Meßfühler können Dehnungsmeßstreifen zum Einsatz gelangen. Die Klebevorbereitung kann dabei ganzflächig aber auch nur teilweise auf der Seite der Leiterplatte vorgesehen sein, die im montierten Zustand auf dem Meßwertaufnehmer haften soll. Durch die Verklebung der Leiterplatte mit dem Meßwertaufnehmer ergibt sich vorteilhaft, daß ein unbeabsichtigtes Verrutschen der Leiterplatte während der Montage und des späteren betriebsmäßigen Einsatzes nicht mehr möglich ist.

Die Anschlußelemente weisen vorteilhaft ein geringeres flächiges Ausmaß auf, als die Kontaktzonen, die ihrerseits mindestens einen Teil der Kontaktflächen abdecken.

Gemäß einer besonderen Ausgestaltung der Erfindung werden die Anschlußelemente aus verzinnten Abschnitten der Leiterbahnen der Leiterplatte gebildet. Vorteilhaft Gemäß einer besonderen Ausgestaltung der Erfindung werden die Anschlußelemente aus verzinnten Abschnitten der Leiterbahnen der Leiterplatte gebildet. Vorteilhaft weist die Leiterplatte im Bereich der auf ihr angeordneten Kontaktzone ein diese bildendes Fenster auf, in welchem ein entsprechendes Anschlußelement angeordnet ist. Die Fenster können vorteilhaft einen kreisrunden Querschnitt aufweisen. Vorteilhaft können auch flächige Anschlußelemente eingesetzt werden, die den Querschnitt der Kontaktzonen etwas mehr verringern, jedoch eine u.U. erforderliche größere Haftfläche zur Verfügung stellen.

Gemäß einer besonderen Ausgestaltung der Erfindung können die Anschlußelemente auch aus verzinnten, aus der Leiterplatte herausragenden Abschnitten der Leiterbahnen gebildet werden.

Vorteilhaft weist die Leiterplatte einen Abschnitt auf, der relativ zum Meßwertaufnehmer beweglich ist und einseitig freigelgte und verzinnte Lötaugen als Kontaktstellen aufweist, um daran die nach außen zu führenden Anschlußleitungen verlöten zu können.

Ein weiterer Vorteil der Erfindung ist dadurch gegeben, daß die Leiterplatte derart montierbar ist, daß die Meßfühler abgedeckt sind und somit die Leiterplatte einen zusätzlichen Schutz für die Meßfühler bildet.

Weitere bevorzugte Ausgestaltungen der Erfindung ergeben sich aus den Unteransprüchen.

Ein Ausführungsbeispiel wird nachfolgend unter Bezugnahme auf ein Blatt mit Zeichnungen näher erläutert. Darin zeigt:
- Fig. 1: eine erfindungsgemäße auf einen Meßwertaufnehmer montierte Leiterplatte, mit teilweise verlöteten Kontaktzonen und Kontaktstellen,
- Fig. 2: eine entsprechend der Linie A-B der Fig. 1 geschnittene Ansicht der Fig. 1,
- Fig. 2a: eine Einzelheit der Fig. 2, und
- Fig. 3a bis Fig. 3d: eine Draufsicht von verschiedenen Varianten der Kontaktzonen entsprechend Fig. 1.

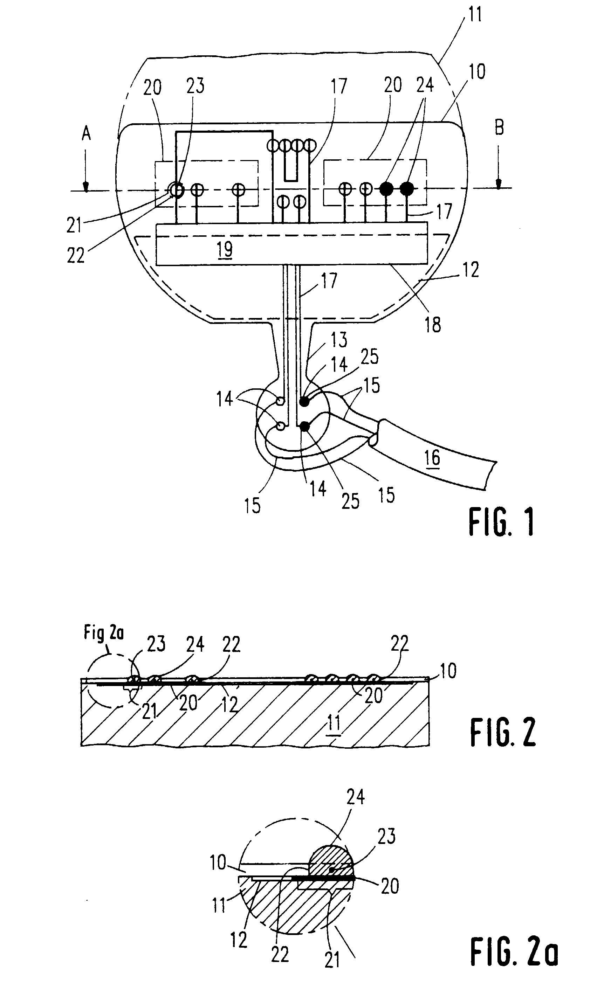

Fig. 1 zeigt eine erfindungsgemäße flexible Leiterplatte 10, die auf einem gestrichelt angedeuteten Meßwertaufnehmer 11 befestigt, vorzugsweise mittels einer Klebevorbereitung 12 mit diesem verklebt ist. Die Klebevorbereitung 12 ist auf der auf dem Meßwertaufnehmer 11 zu befestigenden Seite der Leiterplatte 10 ganzflächig oder wie in Fig. 1 dargestellt, nur teilflächig ausgebildet. Vor der Montage der Leiterplatte 10 kann die Klebevorbereitung 12 mit einer nicht dargestellten abziehbaren Schutzfolie versiegelt sein.

Die Leiterplatte 10 weist einen Abschnitt 13 auf, der relativ zum Meßwertaufnehmer 11 im montierten Zustand der Leiterplatte 10 beweglich ist und einseitig freigelegte und verzinnte Lötaugen als Kontaktstellen 14 an seinem äußeren Ende aufweist, die mit Anschlußleitungen 15 beispielsweise eines Kabels 16 verlötbar sind. Hierdurch ist eine mechanisch robuste Signalübertragung gewährleistet.

Die Leiterplatte 10, die aus herkömmlichem Material, wie z.B. Pyralux® mit Leiterbahnen 17 aus Kupfer hergestellt sein kann, weist einen Bereich 18 auf, auf dem eine Anzahl von elektrischen Bauelementen, z.B. Widerstände angeordnet sind, die eine Abgleichschaltung 19 bilden.

Die Leiterplatte 10 ist oberhalb, teil- oder ganzflächig auf gestrichelt angedeuteten Meßfühlern 20 positioniert, die ihrerseits auf dem Meßwertumformer 11 angeordnet sind. Bei Kraftaufnehmern o.dgl. werden als Meßfühler 20 bevorzugt Dehnungsmeßstreifen eingesetzt, bei denen es sich sowohl um mit geeigneten Isolierträgern laminierte Metallfolien als auch um Dünnfilmapplikationen handeln kann.

Die Kontaktflächen 21 der Meßfühler werden mindestens teilweise von Kontaktzonen 22 der Leiterplatte 10 überdeckt. Die Kontaktzonen 22 sind vorteilhaft kreisrunde Fenster in der Leiterplatte 10, die mit mindestens einem Anschlußelement 23 versehen sind. Vorteilhaft kann ein Anschlußelement 23 aus einem abisolierten und verzinnten Abschnitt der entsprechenden Leiterbahn 17 gebildet werden. Weitere Varianten der Kontaktzone 22 sind weiter unten erläutert.

Die derart gestaltete und befestigte Leiterplatte 10 kann in vorteilhafter Weise dadurch mit den Meßfühlern 20 kontaktiert werden, daß lediglich ein Lot 24 in der Kontaktzone 22 angebracht werden muß, da dadurch quasi automatisch das Anschlußelement 23 mit der Kontaktfläche 21 des Meßfühlers 23 elektrisch und auch mechanisch verbunden wird. Die in Fig. 1 geschwärzten Punkte stellen das Lot 24 bzw. 25 dar.

Fig. 2 zeigt einen Schnitt entlang der Linie A-B der Fig. 1. Oberhalb des angedeuteten Meßwertaufnehmers 11 ist die Klebevorbereitung 12 zu erkennen, ebenso wie die Meßfühler 20 und die Leiterplatte 10. In der Leiterplatte 10 sind die Fenster der Kontaktzonen 22 zu erkennen, die oberhalb der Kontaktflächen 21 angeordnet sind. Die Kontaktzonen 22 sind jeweils mit einem Lot 24 versehen und enthalten beispielsweise je ein Anschlußelement 23. Eine Vergrößerung dieser Verhältnisse ist in Fig. 2a dargestellt. Die Kontaktflächen 21 können, wie angedeutet, etwas größer aber auch etwas kleiner als die Kontaktzonen 22 ausgebildet sein, sofern sie mit den Anschlußelementen 23 korrespondieren.

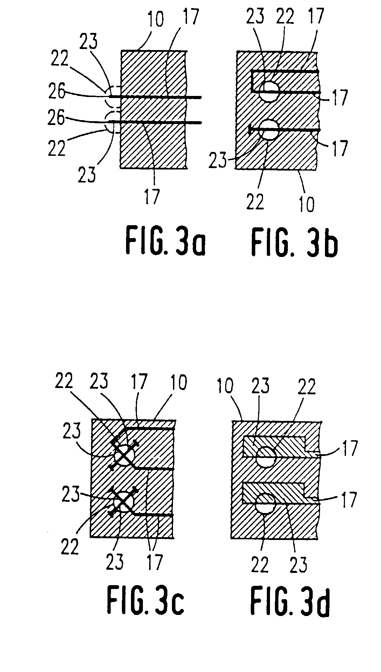

In Fig. 3a bis 3d sind verschiedene Varianten nach der Kontaktzonen 22 aus Fig. 1 dargestellt. Aus Fig. 3a geht eine Variante hervor, bei der die Anschlußelemente 23 aus abisolierten und verzinnten aus der Leiterplatte 10 herausragenden Abschnitten 26 der Leiterbahnen 17 bestehen. Bei dieser Variante werden die Kontaktzonen 22 durch den die Anschlußelemente 23 umgebenden gestrichelt angedeuteten Raum gebildet. Fig. 3b zeigt eine Variante, bei der kreisrunde Fenster die Kontaktzonen 22 bilden. Die Anschlußelemente 23 werden durch abisolierte, verzinnte Abschnitte der Leiterbahnen 17 gebildet. Die obere Kontaktzone 22 weist weiterführende Leiterbahnen 17 und die untere Kontaktzone 22 endende Leiterbahnen 17 auf. Fig. 3c zeigt eine Variante, die der aus Fig. 3b entspricht, allerdings zusätzlich ein weiteres Anschlußelement 23 aufweist, das im Winkel zu dem nach Fig. 3b angeordnet ist. Fig. 3d zeigt eine Variante, bei der ein flächig ausgebildetes Anschlußelement 23 in den Kontaktzonen 22 angeordnet ist und den freien Querschnitt der Kontaktzone 22 erheblich verringert, und gleichzeitig eine mechanisch stabilere Verbindung gewährleistet.

Die derart mit Anschlußelementen 23 versehenen Kontaktzonen 22, hier sei angemerkt, daß auch jede andere Ausgestaltung der Anschlußelemente 23 in den Fenstern denkbar ist, werden in einem Arbeitsgang auf die darunter befindlichen Kontaktflächen 21 der Meßfühler 20 positioniert und verlötet. Ferner sei angemerkt, daß die auf der Leiterplatte angeordnete Abgleichschaltung 19 elektrisch aktiv oder passiv ausgestaltet sein kann, so daß eine kompakte, robuste Anordnung nach der Montage entsteht, deren Signale über das robuste Anschlußkabel 16 zu einer Auswerteelektronik gelangen können. Ferner wird darauf hingewiesen, daß die Leiterplatte auch auf anderen Gegenständen als einem Meßwertaufnehmer in entsprechender Weise verwendet werden kann.

Die in der vorstehenden Beschreibung, in den Figuren sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Verfahren zum Kontaktieren von mindestens einer zu kontaktierenden Kontaktfläche mit einer mit einer Leiterbahn verbundenen Kontaktzone einer flexiblen Leiterplatte, wobei die Leiterplatte (10) derart befestigt wird, daß deren Kontaktzonen (22) mit den Kontaktflächen (21) aufeinanderliegend korrespondieren, dadurch gekennzeichnet, daß im Bereich der Kontaktzonen (22), die mindestens ein in die Leiterplatte integriertes und von beiden Seiten freigelegtes Anschlußelement aufweisen, von der den Kontaktflächen (21) abgewandten, freiliegenden Seite ein Lot aufgebracht wird zur Kontaktierung der Kontaktzonen (22) mit den Kontaktflächen (21).

2. Flexible Leiterplatte zur Ausführung des Verfahrens nach Anspruch 1, für einen mit mindestens einem Meßfühler versehenen Meßwertaufnehmer, mit Kontaktstellen für Bauelemente einer auf ihr ausgebildeten Abgleichschaltung, mit Kontaktstellen für Anschlußleitungen und Kontaktzonen zur Verbindung mit dem Meßfühler,
dadurch gekennzeichnet, daß die Kontaktzonen (22) der Leiterplatte (10) mit den Kontaktflächen (21) der Meßfühler (20) korrespondieren und aufeinander befestigt zusammenwirken, und daß jede Kontaktzone (22) mindestens ein in die Leiterplatte integriertes und von beiden Seiten freigelegtes Anschlußelement (23) aufweist und über dieses direkt mit der entsprechenden Kontaktfläche (21) kontaktierbar ist.

3. Leiterplatte nach Anspruch 2,
dadurch gekennzeichnet, daß die Leiterplatte (10) einen Bereich mit einer Klebevorbereitung (12) zu seiner Befestigung auf dem Meßwertaufnehmer (11) aufweist, der Dehnungsmeßstreifen als Meßfühler (20) trägt.

4. Leiterplatte nach Anspruch 3,
dadurch gekennzeichnet, daß die Anschlußelemente (23) ein geringeres flächiges Ausmaß aufweisen als die Kontaktzonen (22), die ihrerseits mindestens einen Teil der Kontaktflächen (21) abdecken.

5. Leiterplatte nach Anspruch 4,
dadurch gekennzeichnet, daß die Anschlußelemente (23) aus abisolierten, verzinnten Abschnitten der Leiterbahnen (17) der Leiterplatte (10) gebildet werden.

6. Leiterplatte nach Anspruch 5,
dadurch gekennzeichnet, daß die Leiterplatte (10) im Bereich der auf ihr angeordneten Kontaktzonen (22) diese bildende Fenster aufweist, in denen die Anschlußelemente (23) angeordnet sind.

7. Leiterplatte nach Anspruch 6,
dadurch gekennzeichnet, daß die die Kontaktzonen (22) bildenden Fenster einen kreisrunden Querschnitt haben.

8. Leiterplatte nach Anspruch 6,
dadurch gekennzeichnet, daß die Kontaktzonen (22) flächige Anschlußelemente (23) aufweisen, die den Querschnitt der Kontaktzonen (22) teilweise seitlich abdecken.

9. Leiterplatte nach Anspruch 4,
dadurch gekennzeichnet, daß die Anschlußelemente (23) aus abisolierten, verzinnten, aus der Leiterplatte (10) herausragenden Abschnitten (26) der Leiterbahnen (17) gebildet werden.

10. Leiterplatte nach einem oder mehreren der vorherstehenden Ansprüche,
dadurch gekennzeichnet, daß die Leiterplatte (10) einen Abschnitt (13) aufweist, der relativ zu dem Meßwertaufnehmer (11) im montierten Zustand beweglich ist und einseitig freigelegte und verzinnte Lötaugen als Kontaktstellen (14) aufweist, zum Anschluß der Anschlußleitungen (15 bzw. 16).

## Claims

1. A method of contacting at least one contact surface to be contacted by means of a contact zone of a flexible printed board connected to a conductor track, said printed board (10) being fastened such that its contact zones (22) correspond to the contact surfaces (21) by lying thereon, characterized in that a solder is provided from the exposed side facing away from the contact surfaces (21) in the regions of the contact zones (22), which zones each comprise at least one connection element which is integrated in the printed board and is exposed at both sides, for the purpose of contacting the contact zones (22) with the contact surfaces (21).

2. A flexible printed board for carrying out the method as claimed in Claim 1, designed for a transducer provided with at least one probe, with contact areas for components of a compensation circuit arranged on this board and with contact areas for connection lines and contact zones for connection to the probe, characterized in that the contact zones (22) of the printed board (10) correspond to the contact surfaces (21) of the probes (20) and cooperate by being fastened to one another, and in that each contact zone (22) has at least one connection element (23) which is integrated in the printed board and exposed at both sides and can thereby make contact directly with the corresponding contact surface (21).

3. A printed board as claimed in Claim 2, characterized in that the printed board (10) comprises an area with an adhesive compound (12) for fastening on the transducer (11), which carries strain gauge strips as the probes (20).

4. A printed board as claimed in Claim 3, characterized in that the connection elements (23) occupy a smaller surface area than the contact zones (22), which in their turn cover at least a portion of the contact surfaces (21).

5. A printed board as claimed in Claim 4, characterized in that the connection elements (23) are formed from insulated, solder-coated portions of the conductor tracks (17) of the printed board (10).

6. A printed board as claimed in Claim 5, characterized in that the printed board (10) comprises, in the area of the contact zones (22) provided thereon, windows forming these zones, in which windows the connection elements (23) are provided.

7. A printed board as claimed in Claim 6, characterized in that the windows forming the contact zones (22) have a circular cross-section.

8. A printed board as claimed in Claim 6, characterized in that the contact zones (22) have surface-flush connection elements (23) which partly cover the cross-section of the contact zones (22) in lateral direction.

9. A printed board as claimed in Claim 4, characterized in that the connection elements (23) are formed from insulated, solder-coated portions (26) of the conductor tracks (17) projecting from the printed board (10).

10. A printed board as claimed in any one or several of the preceding Claims, characterized in that the printed board (10) comprises a portion (13) which is movable relative to the transducer (11) in the assembled condition and comprises solder-coated lands as the contact areas (14) exposed at one side for connecting the connection lines (15, 16).

## Revendications

1. Procédé pour mettre en contact au moins une surface de contact avec une zone de contact reliée à une piste d'interconnexion d'une plaquette à circuit imprimé flexible, la plaquette à circuit imprimé (10) étant fixée de telle manière que ses zones de contact (22) correspondent par superposition aux surfaces de contact (21), caractérisé en ce que, dans la région des zones de contact (22), qui présente au moins un élément de connexion intégré à la plaquette à circuit imprimé et dégagé des deux côtés, du côté dégagé opposé aux surfaces de contact (21), un métal de brasage est appliqué pour mettre en contact les zones de contact (22) avec les surfaces de contact (21).

2. Plaquette à circuit imprimé flexible pour exécuter le procédé selon la revendication 1, pour un transducteur pourvu d'au moins un capteur de mesure, avec des endroits de contact pour des composants d'un circuit d'équilibrage formé sur la plaque, avec des endroits de contact pour des lignes de connexion et des zones de contact à relier au capteur de mesure, caractérisée en ce que les zones de contact (22) de la plaquette à circuit imprimé (10) correspondent aux surfaces de contact (21) des capteurs de mesure (20) et opèrent conjointement fixées l'une à l'autre, et en ce que chaque zone de contact (22) présente au moins un élément de connexion (23) intégré à la plaquette à circuit imprimé et dégagé de deux côtés et peut être mise en contact, via cet élément, directement avec les surfaces de contact (21) correspondantes.

3. Plaquette à circuit imprimé selon la revendication 2, caractérisée en ce que la plaquette à circuit imprimé (10) présente une région avec une préparation de collage (12) qui permet de la fixer sur le transducteur (11), qui porte des jauges de contrainte comme capteurs de mesure (20).

4. Plaquette à circuit imprimé selon la revendication 3, caractérisée en ce que les éléments de connexion (23) présentent avantageusement des dimensions moindres en surface que les zones de contact (22) qui recouvrent pour leur part au moins une partie des surfaces de contact (21).

5. Plaquette à circuit imprimé selon la revendication 4, caractérisée en ce que les éléments de connexion (23) sont formés de sections étamées et isolées des pistes d'interconnexion (17) de la plaquette à circuit imprimé (10).

6. Plaquette à circuit imprimé selon la revendication 5, caractérisée en ce que la plaquette à circuit imprimé (10) présente, dans la région dès zones de contact (22) qui sont prévues sur cette plaquette, des fenêtres formant ces zones, dans lesquelles sont agencés les éléments de connexion (23).

7. Plaquette à circuit imprimé selon la revendication 6, caractérisée en ce que les fenêtres formant les zones de contact (22) ont une section transversale ronde.

8. Plaquette à circuit imprimé selon la revendication 6, caractérisée en ce que les zones de contact (22) présentent des éléments de connexion plats (23), qui recouvrent partiellement latéralement la section transversale des zones de contact (22).

9. Plaquette à circuit imprimé selon la revendication 4, caractérisée en ce que les éléments de connexion (23) sont formés de sections (26), isolées et étamées, des pistes d'interconnexion (17), faisant saillie de la plaquette à circuit imprimé (10).

10. Plaquette à circuit imprimé selon une ou plusieurs des revendications précédentes, caractérisée en ce que la plaquette à circuit imprimé (10) présente une section (13), qui est mobile par rapport au transducteur (11), à l'état monté, et présente des pastilles de brasure dégagées d'un côté et étamées comme endroits de contact (14) à connecter aux lignes de connexion (15 ou 16).
